## Europäisches Patentamt

## European Patent Office

## Office européen des brevets

(11) Veröffentlichungsnummer: **0 025 171**
**B1**

(12) **EUROPÄISCHE PATENTSCHRIFT**

(45) Veröffentlichungstag der Patentschrift:
**18.12.85**

(51) Int. Cl.⁴: **G 01 C 3/08**, G 03 B 3/10

(21) Anmeldenummer: **80105060.0**

(22) Anmeldetag: **26.08.80**

(54) **Mit einem Belichtungsmessteil versehene Schaltung zur sensorgesteuerten Entfernungsmessung.**

(30) Priorität: **10.09.79 DE 2936536**

(43) Veröffentlichungstag der Anmeldung:
**18.03.81 Patentblatt 81/11**

(45) Bekanntmachung des Hinweises auf die Patenterteilung:
**18.12.85 Patentblatt 85/51**

(84) Benannte Vertragsstaaten:
**BE FR GB IT NL**

(56) Entgegenhaltungen:
**DE - A - 2 810 501**
**US - A - 3 931 465**

(73) Patentinhaber: **Siemens Aktiengesellschaft, Berlin und München Wittelsbacherplatz 2, D-8000 München 2 (DE)**

(72) Erfinder: **Herbst, Heiner, Dr., Anechostrasse 29a, D-8000 München 82 (DE)**
Erfinder: **Pfleiderer, Hans-Jörg, Dr., Franz-Krinninger-Weg 23, D-8011 Zorneding (DE)**
Erfinder: **Grassl, Hans-Peter, Dipl.-Phys., Regina-Ullmann-Strasse 34, D-8000 München 81 (DE)**

ACTORUM AG

**Beschreibung**

Die Erfindung bezieht sich auf eine mit einem Belichtungsmessteil versehene Schaltung zur sensorgesteuerten Entfernungsmessung nach dem Oberbegriff des Patentanspruchs 1.

Eine Schaltung dieser Art ist in der DE-A-2 800 448, vgl. insbesondere Fig. 12, beschrieben. Wird dabei einer der linearen Bildsensoren durch einen projizierten Zeilenausschnitt belichtet, der eine grosse Helligkeit aufweist, so treten Schwierigkeiten auf, die darauf beruhen, dass ein Teil der optisch erzeugten Ladung aus den stark belichteten Sensorelementen in die Nachbarelemente überläuft, bevor die Integrationszeit (Zeitspanne, in der eine optische Ladungserzeugung in den belichteten Sensorelementen erfolgt) beendet ist. Das führt jedoch zu Signalverfälschungen in den Sensorelementen, die eine exakte Entfernungsmessung behindern. Zur Abhilfe werden bei dieser Schaltung die ausgelesenen Bildsensorsignale in einem Komparator mit einer einstellbaren Referenzspannung verglichen. Überschreitet die Amplitude der Bildsensorsignale die Referenzspannung, so wird die Frequenz der die Bildsensoren beaufschlagenden Taktimpulsspannung über eine Regelschaltung erhöht, was zu einer Verringerung der Integrationszeit führt. Der schaltungstechnische Aufwand ist dabei jedoch relativ gross.

Eine andere Schaltung zur sensorgesteuerten Entfernungsmessung bzw. zur Scharfeinstellung der Abbildung eines Gegenstandes auf eine Bildebene ist z. B. aus der DE-A-2 813 915 bekannt. Die Integrationszeit ist dort durch die Länge von Taktimpulsen vorgegeben, die an eine die Sensorelemente eines linearen Bildsensors überdeckende Elektrode angelegt werden. Eine Belichtungsmessung zum Zwecke der Einstellung der Integrationszeit ist dabei nicht vorgesehen.

Eine weitere Schaltung zur automatischen Scharfeinstellung der Abbildung eines Gegenstandes auf eine Bildebene ist der Zeitschrift «Electronics» vom 10.11.1977, S. 40–44, entnehmbar. Hier wird die relative Verschiebung zweier über eine Kameraoptik erhaltener Abbildungen des Gegenstandes mittels zweier flächenhafter Bildsensoren zur Ermittlung der Entfernung des Gegenstandes ausgewertet.

Der Erfindung liegt die Aufgabe zugrunde, bei einer Schaltung der eingangs genannten Art die genannten beschriebenen Schwierigkeiten mit geringem Schaltungsaufwand zu beheben. Diese Aufgabe wird durch die im Patentanspruch 1 gekennzeichneten Merkmale gelöst.

Der mit der Erfindung erzielbare Vorteil liegt neben dem einfachen Schaltungsaufbau insbesondere darin, dass auch ein durch eine stark ungleichmässige Belichtung eines linearen Bildsensors hervorgerufener Überlaufstrom den dem Vergleichs-Sensorelement nachgeschalteten Bewerter beeinflusst und damit die Integrationszeit so rechtzeitig beendet, dass es einerseits zu keinem Überlaufen von Ladung aus den zu stark bestrahlten Sensorelementen in die Nachbarelemente kommt und dass die in den wenig belichteten Sensorelementen angesammelten, optisch erzeugten Ladungen deutlich unter den Bezugsladungen liegen.

Die Unteransprüche sind auf vorteilhafte Ausgestaltungen und Weiterbildungen der Erfindung gerichtet.

Die Erfindung wird nachfolgend anhand der in der Zeichnung dargestellten bevorzugten Ausführungsbeispiele näher erläutert. Dabei zeigt:

Fig. 1 ein erstes Ausführungsbeispiel,

Fig. 2 eine Teilschaltung von Fig. 1,

Fig. 3 Spannungs-Zeit-Diagramme zur Erläuterung der Fig. 1 und 2,

Fig. 4 eine erste Ausgestaltung der Bildsensoren nach Fig. 1,

Fig. 5 eine schaltungstechnische Alternative zu Fig. 4,

Fig. 6 eine zweite schaltungstechnische Alternative zu Fig. 4,

Fig. 7 ein zweites Ausführungsbeispiel und

Fig. 8 ein drittes Ausführungsbeispiel der Erfindung.

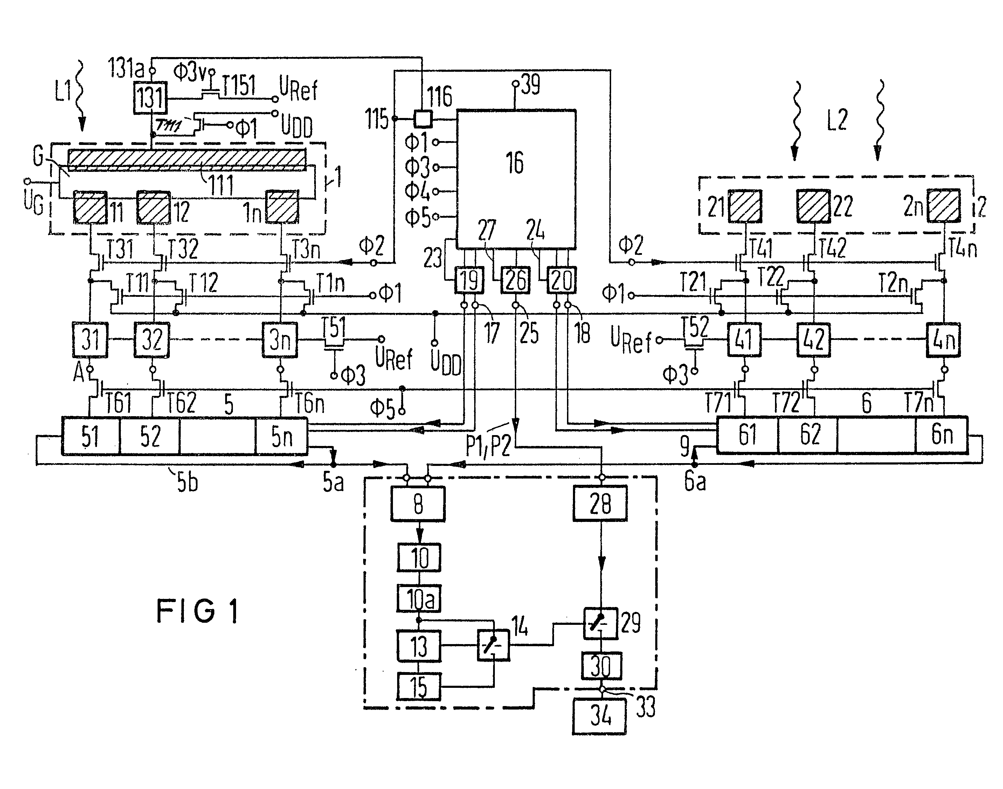

Die in Fig. 1 dargestellte Schaltung enthält zwei lineare Bildsensoren 1 und 2, die mit Sensorelementen 11, 12 ... 1n und 21, 22 ... 2n bestückt sind. Die Bildsensoren 1, 2 sind auf einem dotierten Halbleiterkörper eines ersten Leitfähigkeitstyps integriert. Werden die Sensorelemente als Fotodioden realisiert, so stellen die schraffierten Rechtecke an einer Grenzfläche des Halbleiterkörpers angeordnete Bereiche eines zu dem ersten entgegengesetzten, zweiten Leitfähigkeitstyps dar. Die Sensorelemente 11 ... 1n und 21 ... 2n sind über in Serie geschaltete, individuell zugeordnete Schalttransistoren T11 ... T1n und T31 ... T3n bzw. T21 ... T2n und T41 ... T4n mit Anschlüssen verbunden, die mit einer Versorgungsspannung $U_{DD}$ beschaltet sind. Die Gateelektroden der Schalttransistoren T11 ... T1n und T21 ... T2n sind jeweils an einen gemeinsamen Anschluss geführt, dem eine Taktimpulsspannung $\Phi 1$ zugeführt wird. Die Sensorelemente 11 ... 1n und 21 ... 2n sind anderseits über die Schalttransistoren T31 ... T3n und T41 ... T4n, deren Gateelektroden mit einer gemeinsamen Taktimpulsspannung $\Phi 2$ beschaltet sind, mit den Eingängen von Bewertern 31 ... 3n und 41 ... 4n verbunden.

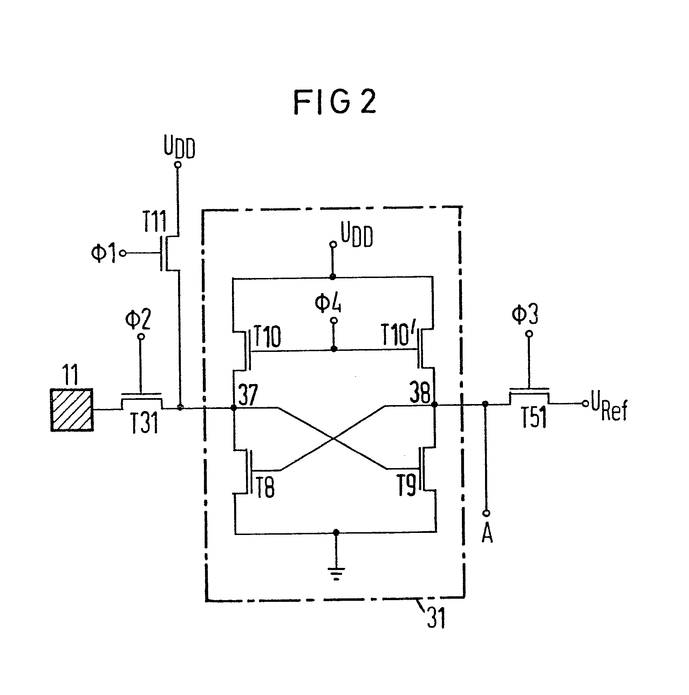

Eine zweckmässige schaltungstechnische Durchbildung der Bewerter 31 ... 3n und 41 ... 4n soll anhand der Fig. 2 noch näher beschrieben werden. Weitere Eingänge dieser Bewerter sind über gemeinsame Schalttransistoren T51 und T52, deren Gateelektroden mit einer Taktimpulsspannung $\Phi 3$ beschaltet sind, an Anschlüsse geführt, die an einer Referenzspannung $U_{Ref}$ liegen. Die Bewerter 31 ... 3n und 41 ... 4n können in Abhängigkeit von den Spannungen, die ihnen über die Schalttransistoren T31 ... T3n und T41 ... T4n zugeführt werden, einen von zwei möglichen Schaltzuständen einnehmen. Ihre Ausgangssignale S11 ... S1n und S21 ... S2n, die je nach dem eingenommenen Schaltzustand dem logischen Spannungspegel «1» oder «0» entsprechen, werden über Transfertransistoren T61 ... T6n und T71 ... T7n, deren Gateelektroden mit einer gemeinsamen Taktimpulsspannung Φ5 beaufschlagt sind, den Eingängen der einzelnen Stufen 51, 52 ... 5n und 61, 62 ... 6n zweier den Bildsensoren individuell zugeordneter Schieberegister 5 und 6 zugeführt, die vorzugsweise als zweiphasige, dynamische Schieberegister ausgebildet sind. Das Schieberegister 5 weist zwei Eingänge auf, die mit Taktimpulsspannungen Φ1L und Φ2L beschaltet sind, während das Schieberegister 6 zwei Eingänge besitzt, denen die Taktimpulsspannungen Φ1R und Φ2R zugeführt werden. Der Ausgang 5a der Stufe 5n ist einerseits über eine Leitung 5b mit dem Eingang der Stufe 51 verbunden und anderseits an einen ersten Eingang einer in einem Auswerteteil 7 angeordneten logischen Schaltung 8 geführt. Der Ausgang 6a der Stufe 6n ist in entsprechender Weise über eine Leitung 9 an den Eingang der Stufe 61 geführt und anderseits mit einem zweiten Eingang von 8 verbunden.

Der logischen Schaltung 8 ist ein Zähler 10 nachgeschaltet, dessen Ausgang mit dem ersten Eingang eines digitalen Komparators 13 und über einen elektronischen Schalter 14 mit einem Speicher 15 verbunden ist. Der Ausgang des Speichers 15 ist an einen zweiten Eingang des digitalen Komparators 13 geführt.

Ein Taktimpulsgeber 16 ist mit Ausgängen für die Taktimpulsspannungen Φ1 bis Φ3 und Φ5 versehen. Über weitere Ausgänge 17 und 18 werden die Taktimpulsspannungen Φ1L und Φ2L sowie Φ1R und Φ2R abgegeben, wobei in Serie zu den Ausgängen 17 eine Torschaltung 19 und in Serie zu den Ausgängen 18 eine Torschaltung 20 angeordnet sind. Die Steuereingänge von 19 und 20 werden über Leitungen 23 und 24 mit noch näher zu beschreibenden Steuersignalen beaufschlagt. Der Taktimpulsgeber weist einen weiteren Ausgang 25 auf, zu dem eine weitere Torschaltung 26 in Serie angeordnet ist. Diese wird über eine Leitung 27 mit einem weiteren Steuersignal belegt. Der Ausgang 25 ist mit dem Eingang eines Zählers 28 verbunden, dessen Ausgang über einen elektronischen Schalter 29 mit einem Speicher 30 in Verbindung steht. Der Ausgang 33 des Speichers 30 ist mit einer weiter unten beschriebenen Vorrichtung 34 beschaltet.

Neben den Sensorelementen 11 ... 1n ist ein streifenförmig ausgebildetes Vergleichs-Sensorelement 111 angeordnet, dessen Längsachse nach einer parallel zum Bildsensor 1 verlaufenden Linie ausgerichtet ist. Das Vergleichs-Sensorelement ist als eine Fotodiode realisiert, wobei der in Fig. 1 schraffiert eingezeichnete Bereich den lateralen Abmessungen eines umdotierten Gebietes des Halbleiterkörpers entspricht. Der zwischen den Sensorelementen 11 ... 1n und dem Vergleichs-Sensorelement 111 liegende Bereich des Halbleiterkörpers wird durch ein mit einer konstanten Spannung U_G beaufschlagtes Gate G überdeckt, das von der Grenzfläche des Halbleiterkörpers durch eine dünne Isolierschicht getrennt ist.

Das Vergleichs-Sensorelement 111 ist über einen Schalttransistor T111 mit einem Anschluss verbunden, der mit der Versorgungsspannung U_DD beschaltet ist. Dem Gate des Transistors T111 wird die Taktimpulsspannung Φ1 zugeführt. Anderseits ist das Vergleichs-Sensorelement 111 mit dem Eingang eines Bewerters 131 verbunden, der den Bewertern 31 ... 3n und 41 ... 4n im Aufbau entspricht. Dem Bewerter 131 wird über einen mit einer Taktimpulsspannung Φ3V beaufschlagten Schalttransistor T151 die Referenzspannung U_Ref zugeführt. Der Ausgang 131a des Bewerters 131 ist mit dem Steuereingang einer Torschaltung 116 verbunden. Diese ist in Serie zu einem Ausgang 115 des Taktimpulsgebers 16 angeordnet, an dem die Taktimpulsspannung Φ2 abgreifbar ist. Die Schaltungsteile G, 111, T111, 131 und T151 stellen den Belichtungsmessteil der Schaltung dar, dessen Ausgang durch 131a gebildet wird.

Fig. 2 zeigt eine zweckmässige Ausgestaltung der Bewerter 31 ... 3n, 41 ... 4n und 131 anhand des Bewerters 31. Er besteht aus einer Flip-Flop-Schaltung mit den Schalttransistoren T8 und T9 und den als schaltbare Lastelemente betriebenen Transistoren T10 und T10'. Die Source-Anschlüsse von T8 und T9 sind über einen gemeinsamen Anschluss 35 an das Bezugspotential der Schaltung angeschlossen, die Drainanschlüsse von T10 und T10' über einen gemeinsamen Anschluss an die Versorgungsspannung U_DD. Der Eingangsknoten des Bewerters 31 ist mit 37 bezeichnet, der Ausgangsknoten mit 38. Zwischen den Gateelektroden von T8 und T9 und den Knoten 37 und 38 besteht eine Kreuzkopplung. Die Gateelektroden von T10 und T10' der Bewerter 31 ... 3n und 41 ... 4n sind über einen gemeinsamen Anschluss mit einer Taktimpulsspannung Φ4 beschaltet. Die an die Knoten 37 und 38 angeschlossenen Schaltungsteile T11, 11 und T31 sowie T51 wurden bereits anhand der Fig. 1 beschrieben.

Das bei der Erfindung verwendete Prinzip der Entfernungsmessung eines Gegenstandes geht davon aus, dass von diesem über zwei optische Einrichtungen zwei getrennte Abbildungen gewonnen werden, deren entfernungsabhängige Relativpositionen ausgewertet werden. Die Lichtstrahlen L1 in Fig. 1 gehen dabei von dem in seiner Entfernung zu bestimmenden Gegenstand aus. Sie projizieren über eine erste optische Einrichtung eine Abbildung desselben in der Weise auf die Ebene des Bildsensors 1, dass dieser auf einen Zeilenausschnitt der Abbildung ausgerichtet ist. In analoger Weise projizieren die Lichtstrahlen L2, die über eine zweite optische Einrichtung von dem Gegenstand gewonnen werden, eine zweite Abbildung desselben auf die Ebene des Bildsensors 2, und zwar derart, dass dieser auf den gleichen Zeilenausschnitt gerichtet ist, wenn sich der Gegenstand in einem vorgegebenen Abstand, z.B. im Abstand «unendlich» befindet. Verändert sich der Abstand des Gegenstandes gegenüber dem vorgegebenen Wert, so verschieben sich die auf die Bildsensoren 1 und 2 projizierten Zeilenausschnitte dementsprechend in Längsrichtung der Bildsensoren. Die Grösse der gegenseitigen Verschiebung stellt dabei ein Mass für die tatsächliche Entfernung des Gegenstandes dar. Eine ähnliche Methode der Entfernungsmessung, bei der die vorstehend beschriebenen relativen Verschiebungen zweier Abbildungen des Gegenstandes ausgenutzt werden, aber anstelle von linearen Bildsensoren flächenhafte Anordnungen von Fotodioden vorgesehen sind, ist beispielsweise aus der Zeitschrift «Electronics» vom 10.11.1977, Seiten 40 bis 44, bekannt.

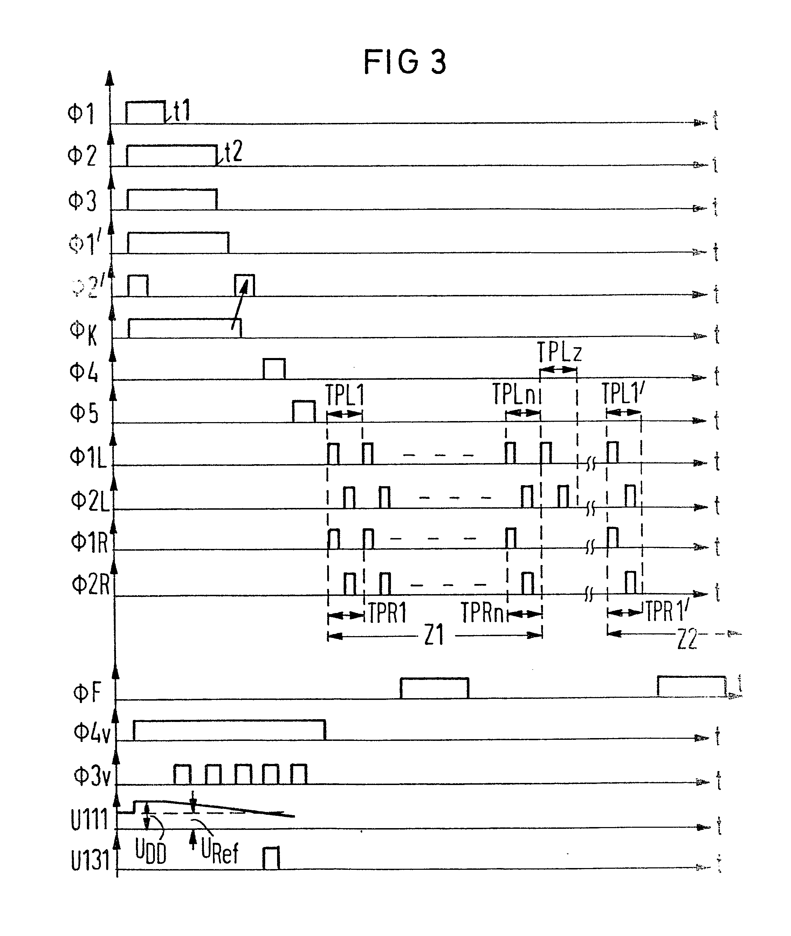

Die Wirkungsweise der Schaltung nach den Fig. 1 und 2 ergibt sich in Verbindung mit den Impuls-Zeit-Diagrammen nach Fig. 3. Wird einem Eingang 39 des Taktimpulsgebers 16 ein Triggerimpuls zugeführt, so gibt dieser zunächst Taktimpulse $\Phi 1$ und $\Phi 2$ ab. Damit werden die Sensorelemente, z.B. 11, und die Eingangsknoten, z.B. 37, der Bewerter 31 ... 3n und 41 ... 4n über die leitenden Transistoren, z.B. T11 und T31, auf die Versorgungsspannung $U_{DD}$ rückgesetzt. Ein gleichzeitig beginnender Taktimpuls $\Phi 3$ schaltet T51 in den leitenden Zustand, so dass der Ausgangsknoten 38 auf die Referenzspannung $U_{Ref}$ gelegt wird. Beim Abschalten des Taktimpulses $\Phi 1$ beginnen sich in den Sensorelementen, z.B. 11, durch die einfallenden Lichtstrahlen L1 bzw. L2 erzeugte Ladungsträger anzusammeln, wobei in den Sensorelementen ein Spannungsabfall entsteht. Je grösser die in den Sensorelementen 11 ... 1n und 21 ... 2n jeweils angesammelten, optisch erzeugten Ladungen sind, desto stärker verringert sich das Potential an den zugeordneten Eingangsknoten, z.B. 37, der Bewerter. Die Zeitspanne zwischen dem Ende des Taktimpulses $\Phi 1$ zum Zeitpunkt t1 und dem Ende des Taktimpulses $\Phi 2$ zum Zeitpunkt t2 wird als Integrationszeit $T_i$ bezeichnet. Nur innerhalb dieser Zeitspanne sammeln sich optisch erzeugte Ladungen in den Sensorelementen an.

Nach Beendigung des Taktimpulses $\Phi 2$ und nach Beendigung des Taktimpulses $\Phi 3$ wird ein Taktimpuls $\Phi 4$, der an einem weiteren Ausgang des Taktimpulsgebers abgreifbar ist, an die Gateelektroden von T10 und T10' gelegt, so dass die Flip-Flop-Schaltungen der Bewerter 31 ... 3n und 41 ... 4n aktiviert werden. Am Ausgangsknoten, z.B. 38, stellt sich für den Fall, dass am Knoten 37 ein solcher Spannungsabfall aufgetreten war, dass die Referenzspannung $U_{Ref}$ unterschritten wurde, eine Spannung ein, die etwa der Versorgungsspannung $U_{DD}$ entspricht (logische «1»). Wird dagegen $U_{Ref}$ durch die Spannung am Knoten 37 nicht unterschritten, so gelangt der Knoten 38 auf ein Potential, das etwa dem Bezugspotential am Anschluss 35 entspricht (logische «0»). Damit gibt jeder Bewerter ein digitalisiertes Sensorsignal, z.B. S11, ab, dessen Wert abhängig ist vom Erreichen oder Nichterreichen einer Bezugsladung in den einzelnen Sensorelementen, die gerade dann vorliegt, wenn das Potential am Knoten 37 zum Zeitpunkt t2 dem Potential des auf die Spannung $U_{Ref}$ rückgesetzten Knotens 38 gleichkommt.

Zum Bestimmen der optimalen Integrationszeit dienen die Schaltungsteile G, 111, T111, 131 und T151. Im Vergleichs-Sensorelement 111 sammelt sich nach dem Zeitpunkt t1, d.h. nach der rückwärtigen Flanke von $\Phi 1'$, eine optisch erzeugte Ladung an, die jeweils dem Mittelwert der Belichtung aller Sensorelemente 11 ... 1n entspricht, die sich neben dem Vergleichs-Sensorelement 111 befinden. Da dieser Mittelwert bei einer sehr starken Belichtung eines kleinen Teiles der Sensorelementenzeile 11 ... 1n und einer sehr geringen Belichtung des übrigen, wesentlich grösseren Teiles derselben nur wenig grösser ist als der Dunkelwert, der sich bei einem dunklen Zeilenausschnitt einstellen würde, wird die Bezugsladung, bei der der Bewerter 131 in den Schaltzustand umgeschaltet wird, indem er ein logisches Ausgangssignal «1» abgibt, erst nach einer grösseren Zeitspanne erreicht. Bei einer extrem starken Belichtung einiger Sensorelemente, bei der es zu einem Überlaufen von Teilen der angesammelten, optisch erzeugten Ladungen aus den betroffenen Sensorelementen kommt, überwinden nun die überlaufenden Ladungsteile die unterhalb des Gate G bestehende Potentialschwelle und gelangen in das Vergleichs-Sensorelement 111, dessen Ladungsinhalt dadurch stark erhöht wird, so dass die Bezugsladung wesentlich schneller erreicht wird als vorher.

Durch die optisch in 111 erzeugte Ladung und das Überlaufen von Teilladungen an den Sensorelementen 11 ... 1n in das Vergleichs-Sensorelement 111 sinkt die Spannung U111 an demselben ausgehend von dem Rücksetzwert $U_{DD}$ (Fig. 3) ab. Führt man dem Bewerter 131, der während des Auftretens von einem Taktimpuls $\Phi 4v$ aktiv geschaltet ist, über den Transistor 151 während des Auftretens der Taktimpulse $\Phi 3v$ jeweils $U_{Ref}$ zu, so wird bei dem Taktimpuls $\Phi 3v$, bei dem U111 die Spannung $U_{Ref}$ bereits unterschritten hat, die Umschaltung des Bewerters 131 auf das Ausgangssignal «1» erfolgen. Dieses sperrt die Torschaltung 116 und beendet den Impuls $\Phi 2$, wodurch das Ende der Integrationszeit für die Sensorelemente 11 ... 1n und 21 ... 2n gegeben ist.

Beim Auftreten eines Taktimpulses $\Phi 5$ werden kann die von den Bewertern 31 ... 3n und 41 ... 4n abgegebenen digitalisierten Sensorsignale, z.B. S11, den Eingängen der zugeordneten Stufen, z.B. 51, der Schieberegister 5 und 6 zugeführt und in diesen gespeichert.

Der Taktimpulsgeber 16 liefert anschliessend Taktimpulsfolgen $\Phi 1L$, $\Phi 2L$, $\Phi 1R$ und $\Phi 2R$, die die in den Stufen der Schieberegister 5 und 6 enthaltenen Informationen jeweils um eine Stufe verschieben. Vor dem Auftreten der Taktimpulse 43 und 44, die zu einer Taktperiode TPL1 gehören, erscheint das Sensorsignal S1n am Ausgang 5a. Die Taktimpulse 43 und 44 verschieben die Information S1n in die Stufe 51 und die Information $S1(n-1)$ an den Ausgang 5a, und so weiter. Durch die Taktimpulse 45 und 46 der Taktperiode TPLn gelangt schliesslich nach einem vollen Informationsumlauf wieder das Sensorsignal S1n an den Ausgang 5a. Es folgt eine Taktperiode TPLz mit den Taktimpulsen 47 und 48, durch die das Sensorsignal $S1(n-1)$ am Ausgang 5a erscheint. Nach einer sich anschliessenden, mit 49 bezeichneten Austastlücke schieben die Taktimpulse 53 und 54 der Taktperiode TPL1' die Sensorsignale wieder um eine Stufe weiter, so dass S1(n−1) in die Stufe 51 gelangt und S1(n−2) an den Ausgang 5a durchgeschaltet wird.

In einem ersten Auslesezyklus Z1, der die Taktperioden TPL1 bis TPLn umfasst, werden also die Sensorsignale S1n bis S1 und wieder S1n am Ausgang 5a seriell ausgegeben. In einem zweiten Auslesezyklus Z2, der die Taktperiode TPL1' und n−1 weitere Taktperioden umfasst, erfolgt eine zweite serielle Ausgabe aller Sensorsignale des Bildsensors 1, wobei die Signale S1(n−1) bis S1 und wieder S1n und S1(n−1) an 5a auftreten. Innerhalb des ersten Auslesezyklus Z1 wird das Schieberegister 6 ebenfalls mit n Taktperioden TPR1 bis TPRn beaufschlagt, während den Taktimpulsen 47 und 48 entsprechende Impulse fehlen. Das hat zur Folge, dass zu Beginn von Z2 das Sensorsignal S2n am Ausgang 6a und das Signal S1(n−1) am Ausgang 5a anliegen.

Somit werden im ersten Auslesezyklus Z1 die Signalpaare S1n und S2n, S1(n−1) und S2(n−1) usw. an 5a und 6a seriell ausgelesen, im zweiten Auslesezyklus dagegen die Signalpaare S1(n−1) und S2n, S1(n−2) und S2(n−1) usw. Die seriell ausgelesenen Informationen der Schieberegister 5 und 6 sind also in zwei aufeinander folgenden Auslesezyklen um jeweils eine Signalbreite gegeneinander verschoben. Nach n Auslesezyklen haben sie dann wieder dieselbe zeitliche Zuordnung wie im Zyklus Z1. In Fig. 1 kann diese Verschiebung dadurch erreicht werden, dass die Torschaltung 20 über die Leitung 24 während des Auftretens der Taktimpulse 47 und 48, d.h. zwischen den Taktperioden TPRn und TPR1', gesperrt wird. In diesem Zeitraum kann die Torschaltung 26 über die Steuerleitung 27 geöffnet werden, so dass einer der Impulse 47 oder 48 oder ein von diesen abgeleiteter Impuls am Ausgang 25 als Verschiebeimpuls P1 erscheint. Dieser Verschiebeimpuls P1 kennzeichnet dabei den Beginn eines neuen Auslesezyklus und eine gegenseitige Verschiebung der an den Ausgängen 5a und 6a seriell ausgelesenen Sensorsignale um jeweils eine Signalbreite.

Die innerhalb eines Auslesezyklus, z.B. Z1, ausgelesenen Sensorsignalpaare werden in der logischen Schaltung 8 nach der Exklusiv-Oder-Funktion bewertet. Dabei tritt am Ausgang 55 von 8 immer dann ein Ausgangsimpuls auf, wenn die eingangsseitig über 5a und 6a zugeführten digitalen Signale übereinstimmen. Stimmen sie nicht überein, so wird von 8 kein Ausgangsimpuls abgegeben. Die Teilschaltung 8 kann aber auch so ausgebildet sein, dass sie nur die Übereinstimmung zweier «1»-Signale oder zweier «0»-Signale an ihren Eingängen durch einen Ausgangsimpuls angibt. Der Zähler 10, der vor Beginn jedes Auslesezyklus, also in den Austastlücken 49, auf Null rückgesetzt wird, zählt dann die Anzahl der Übereinstimmungen innerhalb eines solchen Zyklus.

Hierbei wird der Zähler 10 allerdings nur während eines Teils jedes Auslesezyklus wirksam geschaltet, der durch einen von 16 abgegebenen

Impuls $\Phi$F bestimmt wird. Nimmt man an, dass der Zähler 10 im Auslesezyklus Z1 die Übereinstimmungen innerhalb der Taktperioden $TPR_i$ bis $TPR_k$ zählt, wobei die Differenz $k-i$ etwa $n/2$ oder $3n/4$ beträgt, so zählt er im Auslesezyklus Z2 die Übereinstimmungen innerhalb der Taktperioden $TPR'_{i+1}$ bis $TPR'_{k+1}$. Betrachtet man die Impulse $\Phi$F1 und $\Phi$F2 jeweils als «Auslesefenster», so haben sich die Sensorsignale des Schieberegisters 6 im Fenster $\Phi$F2 gegenüber dem Fenster $\Phi$F1 um eine Signalbreite nach links (Fig. 3) verschoben. Im nächsten Auslesezyklus Z3, in dem der entsprechende Impuls $\Phi$F3 dieselben Taktimpulsperioden umfasst wie in Z2, haben sich dann die Signale von 5 im «Fenster» $\Phi$F3 um eine Signalbreite nach rechts verschoben. Wird das «Fenster» generell im ersten Auslesezyklus Z1 und in den weiteren Auslesezyklen Z3, Z5, Z7 usw. um eine Taktperiodenlänge jeweils nach rechts verschoben, so entspricht das einer abwechselnden Verschiebung der an 6a bzw. 5a abgegriffenen Sensorsignalfolgen in dem jeweiligen Fenster $\Phi$F um eine Signalbreite nach links bzw. rechts. Diejenigen Impulse $\Phi$F, die die vom Zeilenanfang und vom Zeilenende einer der Sensorelementenzeilen abgeleiteten Bewertersignale gleichzeitig umschliessen würden, werden vom Taktimpulsgeber 16 unterdrückt. Hierdurch wird erreicht, dass die «Fenster» $\Phi$F die Auswertung von denjenigen Sensorsignalen ausschalten, die von den in vertauschter Zuordnung nebeneinander stehenden Anfangs- und Endabschnitten der projizierten Zeilenausschnitte abgeleitet worden sind, so dass sie keine Aussage über den tatsächlichen Helligkeitsverlauf längs des Zeilenausschnitts vermitteln.

Ist das Zählergebnis, das dem Eingang 56 des digitalen Komparators 13 zugeführt wird, grösser als das an seinem Eingang 57 liegende digitale Signal, so werden die Steuereingänge der Schalter 14 und 29 mit einem Komparatorsignal beaufschlagt, das beide Schalter in solche Schaltzustände bringt, in denen sie die an ihre Eingänge gelegten Signale an die jeweiligen Ausgänge übertragen werden. Nachdem das Zählergebnis der Übereinstimmungen des ersten Informationszyklus Z1 als erstes digitales Signal dem Speicher 15 und über diesen dem Eingang 57 des Komparators zugeführt wird, wird danach nur noch ein solches Zählergebnis eines weiteren Informationszyklus Zi in den Speicher 15 übernommen, das grösser ist als das grösste jeweils zuvor gespeicherte. Die am Ende der Informationszyklen Z1, Z2 und so weiter auftretenden Verschiebeimpulse P1, P2 usw. werden im Zähler 28 gezählt. Da der Schalter 29 synchron mit dem Schalter 14 betätigt wird, überträgt er immer beim Auftreten eines grösseren Zählergebnisses im Zähler 10 den jeweils neuen Zählerstand von 28 auf den Speicher 30. Damit ist im Speicher 30 nach n Informationszyklen die Anzahl der Verschiebeimpulse Pi gespeichert, die eine solche Informationsverschiebung zwischen den Sensorsignalen der Schieberegister 5 und 6 kennzeichnet, bei der die grösste Anzahl von Übereinstimmungen auftritt. Mit anderen Worten: die Anzahl der im Speicher 30 gespeicherten Schiebeimpulse P1, P2 usw. gibt diejenige relative Verschiebung der in den Schieberegistern 5 und 6 umlaufenden Sensorsignale ab, bei der eine maximale Korrelation der miteinander verglichenen Sensorsignale besteht.

Die in Fig. 3 angedeuteten Austastlücken 49, die z.B. zum jeweiligen Rücksetzen des Zählers 10 auf Null erforderlich sind, werden durch eine entsprechende Sperrung der Torschaltungen 19 und 20 über ihre Steuerleitungen 23 und 24 erzeugt.

Das am Ausgang 33 des Speichers 30 auftretende digitale Signal wird einer Vorrichtung 34 zugeführt, die als eine Anzeigevorrichtung aufgefasst werden kann, die nach einer entsprechenden Codierung des digitalen Signals eine digitale oder analoge Anzeige der Entfernung des Gegenstandes liefert. Anderseits kann die Vorrichtung 34 auch aus einer an sich bekannten Einstellvorrichtung einer fotografischen oder elektronischen Kamera bestehen, die den Abstand eines gegenüber einer Bildebene bewegbaren Objektivs so einstellt, dass der Gegenstand auf diese Bildebene scharf abgebildet wird. Eine Vorrichtung dieser Art ist beispielsweise in der deutschen Patentanmeldung P 2 813 915.3 (VPA 78 P 7025) und in der Zeitschrift «Electronics» vom 10. Nov. 1977 auf den Seiten 40 bis 44 beschrieben.

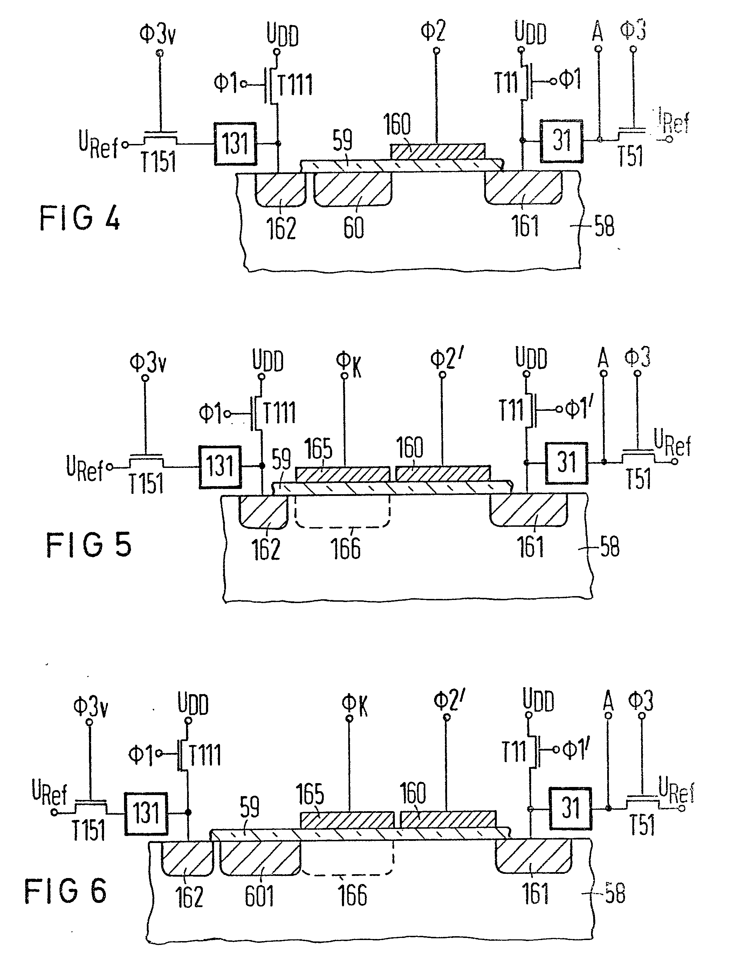

Fig. 4 zeigt eine schaltungstechnische Ausbildung der Sensorelemente 11 ... 1n und 21 ... 2n sowie der angrenzenden Schaltungsteile anhand des Sensorelementes 11. Auf einem dotierten Halbleiterkörper 58, z.B. aus p-dotiertem Silizium, ist eine dünne, elektrisch isolierende Schicht 59, z.B. aus $SiO_2$, vorgesehen. Der Bildsensor 11 ist hierbei als eine Fotodiode ausgebildet, die aus dem n-dotierten Halbleitergebiet 60 besteht. Dieses Gebiet bildet gleichzeitig auch das Sourcegebiet des Transistors T31 (Fig. 1). Das Gate von T31 ist auf der isolierenden Schicht 59 angeordnet und mit 160 bezeichnet. Das Draingebiet von T31 trägt das Bezugszeichen 161. Das Gebiet 161 ist einerseits über den Transistor T11 mit einem Anschluss verbunden, der mit der Versorgungsspannung $U_{DD}$ beschaltet ist, und bildet anderseits den Eingang des Bewerters 31 bzw. das Draingebiet des in diesem vorgesehenen Transistors T8 (Fig. 2) und das Sourcegebiet des Transistors T10. Der zweite Eingang von 31 ist entsprechend Fig. 2 über den mit $\Phi 3$ beaufschlagten Transistor T51 mit einem Anschluss verbunden, der an der Referenzspannung $U_{Ref}$ liegt. Das Vergleichs-Sensorelement 111 ist als eine aus dem n-dotierten Gebiet 162 bestehende Fotodiode ausgebildet. Das Gebiet 162 ist einerseits über den mit $\Phi 1$ beaufschlagten Transistor T111 mit einem Anschluss verbunden, der mit $U_{DD}$ beschaltet ist, und anderseits an den ersten Eingang des Bewerters 131 geführt, dessen zweiter Eingang über einen mit $\Phi 3v$ beaufschlagten Transistor T151 an der Referenzspannung $U_{Ref}$ liegt. Zwischen den Gebieten 60 und 162 befindet sich ein Gate G, das durch die isolierende Schicht 59 von der Grenzfläche 58a der Halbleiterkörper getrennt ist. Es ist mit einer konstanten Spannung $U_G$ beschaltet, die so gewählt ist, dass unterhalb von G eine Potentialbarriere entsteht, die kleiner ist als die zwischen dem Gebiet 60 und den entsprechenden Gebieten der zu 11 benachbarten Sensorelemente.

Eine alternative Schaltung zu Fig. 4 zeigt Fig. 5. Danach besteht das Sensorelement 11 aus einem MIS-Kondensator (Metall-Isolierschicht-Halbleiter-Kondensator), der ein Gate 165 besitzt, das auf der Isolierschicht 59 angeordnet ist. Das Gate 165 ist z.B. aus hochdotiertem polykristallinem Silizium gefertigt und liegt an einer Taktimpulsspannung $\Phi_K$, unter deren Einfluss sich eine Raumladungszone 166 im Halbleiterkörper 58 ausbildet. Die weiteren Schaltungsteile von Fig. 5 entsprechen den mit gleichen Bezugszeichen versehenen Schaltungsteilen von Fig. 4, wobei darauf hingewiesen sei, dass der Transistor T11 mit einer Taktimpulsspannung $\Phi 1'$ und der Transistor T31 mit einer Taktimpulsspannung $\Phi 2'$ belegt ist. Die gleichzeitig beginnenden Taktimpulse $\Phi 1'$, $\Phi 2'$ und $\Phi_K$ bewirken bis zum Zeitpunkt t1 ein Rücksetzen des MIS-Kondensators im Bereich der Grenzfläche 58a des Halbleiterkörpers 58 etwa auf den Wert der Versorgungsspannung $U_{DD}$. Zum Zeitpunkt t1 beginnt in dem weiterhin mit $\Phi_K$ beaufschlagten MIS-Kondensator die Integrationszeit, in der optisch erzeugte Ladungsträger gesammelt werden. Mit dem Ende von $\Phi_K$ zum Zeitpunkt t2' ist auch das Ende der Integrationszeit erreicht. Kurz vor dem Zeitpunkt t2' wird ein neuer Taktimpuls $\Phi 2'$ angelegt, so dass eine durch den Pfeil 504 (Fig. 3) angedeutete Ladungsübernahme von 166 nach 161 stattfinden kann, die am Eingang des Bewerters 31 eine entsprechende Potentialänderung hervorruft. Der Taktimpuls $\Phi 1'$ muss, wie in Fig. 3 angedeutet ist, vor dieser Ladungsübernahme abgeschaltet werden. Das Gate G liegt hierbei zwischen dem Gebiet 162 und dem Gate 165 des MIS-Kondensators.

Fig. 6 unterscheidet sich von Fig. 5 lediglich dadurch, dass eine Fotodiode 601 neben dem MIS-Kondensator 165, 166 angeordnet ist, und zwar auf der von T31 abgewandten Seite desselben. Die Gateelektrode von T31 ist mit der Impulsspannung $\Phi 2'$ beschaltet, während der Gateelektrode von T11 die Taktimpulsspannung $\Phi 1'$ zugeführt wird. Das Gate G liegt dabei zwischen den Gebieten 162 und 601. Die Kapazität des Sensorelements 11 nach Fig. 5 ist grösser als die Kapazität des Sensorelements nach Fig. 4, während die Kapazität des Sensorelements 11 nach Fig. 6 grösser ist als die der Ausführung nach Fig. 5.

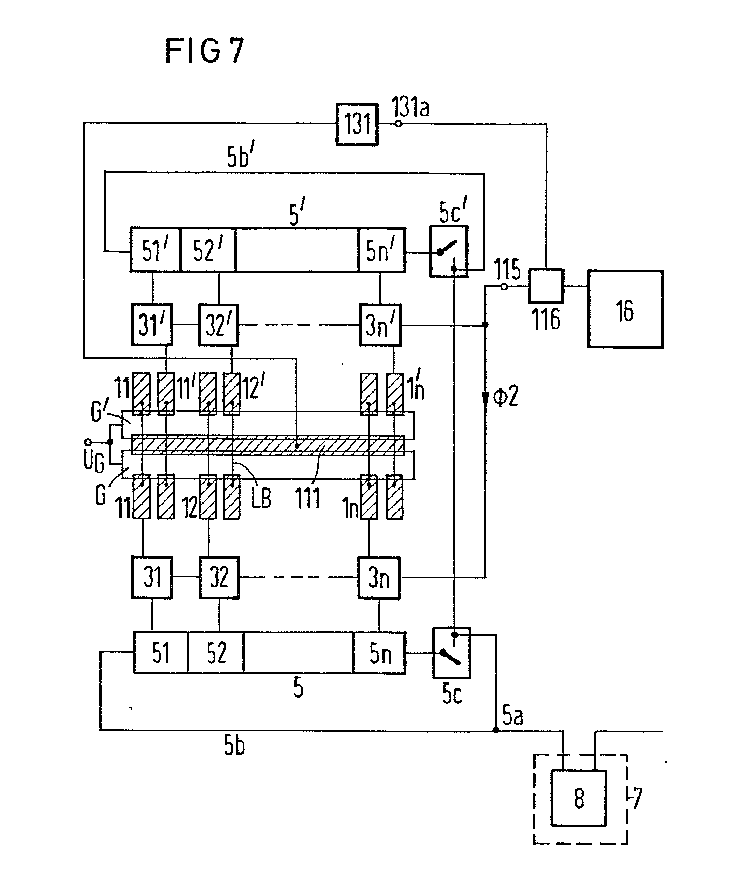

In Fig. 7 ist ein zweites Ausführungsbeispiel der Erfindung dargestellt, bei dem zwei Schaltungen nach Fig. 1 mit einem gemeinsamen Auswerteteil 7 und gemeinsamen, diesem nachgeschalteten Vorrichtungen 34 vorgesehen sind. Die Bestandteile der in Fig. 1 linksseitig vom Auswerteteil 7 angeordneten Teilschaltung sind in Fig. 7 mit denselben Bezugszeichen versehen. Dabei sind die einzelnen Sensorelemente 11, 12 ... 1n in Längsrichtung des Bildsensors 1 so schmal ausgebildet, dass sie etwa der halben Abmessung der Bewerter 31, 32 ... 3n entsprechen. In diese Bewerter wurden der einfachen Darstellung wegen auch die Schalttransistoren T11 usw., T31 usw., T61 usw.,

T111 usw., sowie T151 einbezogen. Die entsprechenden Bestandteile der zweiten Schaltung nach Fig. 1 sind in Fig. 7 jeweils mit Bezugszeichen versehen, die durch einen Strich ergänzt sind. Wie ersichtlich ist, sind die Sensorelemente 12 ... 1n des einen Bildsensors in den Lücken zwischen den Sensorelementen 11', 12' ... 1n' des anderen Bildsensors angeordnet. Die Sensorelemente sind in der Mitte geteilt, wobei ihre Teile jeweils mit einer leitenden Überbrückung, z.B. LB, miteinander verbunden sind. In den Lücken zwischen den jeweiligen Sensorelementeteilen liegt das Vergleichs-Sensorelement 111, dessen undotiertes Gebiet 162 in Fig. 7 schraffiert ist, und die Gates G und G', die an der Spannung $U_G$ liegen. Bei diesem Ausführungsbeispiel kann auf einer der Fig. 1 entsprechenden Sensorlänge die doppelte Anzahl von Sensorelementen untergebracht werden, so dass die Auflösung der auf die Sensorelemente projizierten Zeilenausschnitte wesentlich grösser ist als in Fig. 1. Um eine gegenseitige Störung des Informationsumlaufes in den Schieberegistern 5 und 5' zu verhindern, sind alternierend betätigbare elektronische Schalter 5c und 5c' vorgesehen, die wechselweise einen der Ausgänge 5a und 5a' mit dem einen Eingang der logischen Schaltung 8 und mit dem Eingang der betreffenden ersten Stufe 51 bzw. 51' der Schieberegister verbinden. Sie werden mittels Taktimpulsspannungen $\Phi6$ und $\Phi6'$ angesteuert. Dabei sind die Taktperioden von $\Phi6$ durch gleichlange Zwischenperioden voneinander getrennt. Mit diesen Zwischenperioden fallen die Taktperioden von $\Phi6'$ zeitlich zusammen. Die in Fig. 7 dargestellte Schaltung ist rechtsseitig von dem Auswerteteil 7 durch eine entsprechende Anordnung zweier weiterer Bildsensoren 2 und 2' und der ihnen zugeordneten Bewerter und Schieberegister zu ergänzen, wobei deren Sensorelemente ebenfalls so schmal ausgebildet sind, dass sie der in Längsrichtung der Bildsensoren 2 bzw. 2' gemessenen halben Bewerterbreite entsprechen.

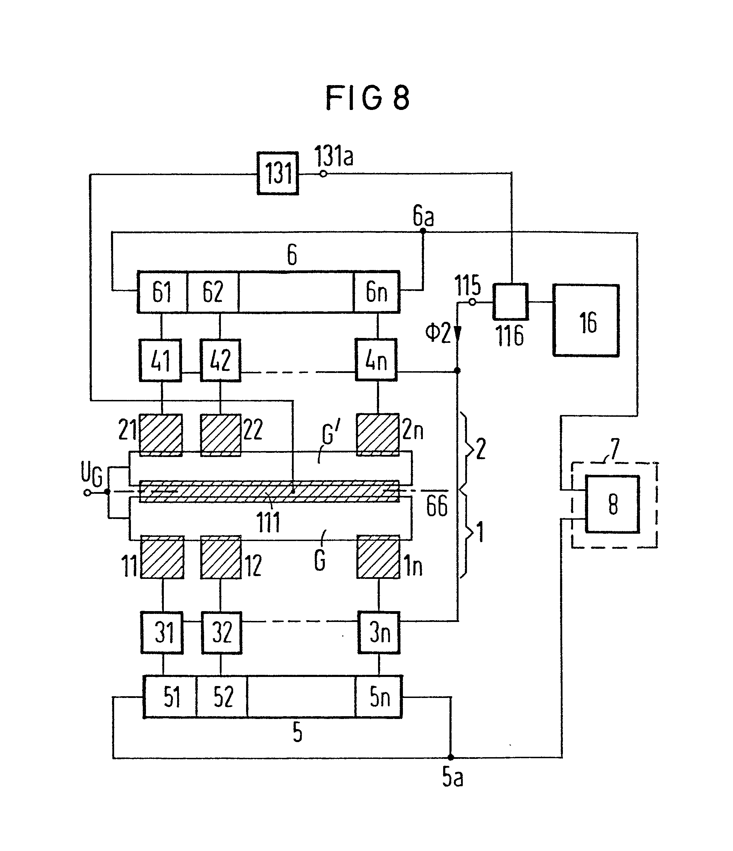

Fig. 8 zeigt schliesslich eine Fig. 1 entsprechende Schaltung, bei der die Bildsensoren 1 und 2 nebeneinander angeordnet sind, so dass ihre Sensorelemente 11, 12 ... 1n und 21, 22 ... 2n in zwei nebeneinander liegenden Zeilen liegen. Die' Bewerter 31, 32 ... 3n und 41, 42 ... 4n enthalten jeweils auch die Schalttransistoren T11 usw. bis T71 usw., die Bewerter 131 ... 13n, die Transistoren T111 usw. und T151. Dieses Ausführungsbeispiel kann herangezogen werden, wenn die Abbildungen des Gegenstandes jeweils nur zur Hälfte auf die Ebene der Bildsensoren von 1 und 2 projiziert werden, wobei die obere Hälfte der einen Abbildung auf den Teil der Bildebene fällt, der oberhalb der Schnittlinie 66 liegt, während die untere Hälfte der anderen Abbildung auf den unterhalb der Schnittlinie 66 liegenden Teil der Bildebene projiziert wird. Die mittels der Bildsensoren 1 und 2 ausgewerteten Zeilenausschnitte liegen dabei an den jeweiligen Grenzen der Abbildungshälften, die der Linie 66 benachbart sind. Bei der Schaltung nach Fig. 8 sind vorzugsweise zwei mit $U_G$ beschaltete Gates G und G' vorgesehen, die zwischen den Sensorelementenzeilen 11 ... 1n bzw. 21 ... 2n und dem Vergleichs-Sensorelement 111 angeordnet sind.

Die beschriebenen und dargestellten Schaltungen können mit besonderem Vorteil ganz oder teilweise auf einem dotierten Halbleiterkörper monolithisch integriert werden. Dabei ist der Halbleiterkörper, z.B. 58, vorzugsweise p-leitend ausgebildet und der übrige Schaltungsaufbau in MOS-n-Kanal-Technik ausgeführt. Der Halbleiterkörper liegt auf einem Bezugspotential, wobei die angegebenen Spannungen und Potentiale gegenüber diesem jeweils ein positives Vorzeichen aufweisen. Bei einem n-leitenden Halbleiterkörper und einer MOS-p-Kanal-Technik werden diese Vorzeichen negativ. Die beschriebenen und dargestellten Ausführungsbeispiele weisen im Bereich der Bildsensoren 1 und 2 Blenden auf, in denen Öffnungen vorgesehen sind, durch die eine Belichtung der Sensorelemente und des Vergleichs-Sensorelements erfolgt. Im Betrieb können beispielsweise folgende Spannungswerte gewählt werden: $U_{DD}$ = 5 bis 12 Volt, $U_G$ = 1 bis 2 Volt, $U_{Ref}$ = $U_{DD}/2$.

## Patentansprüche

1. Mit einem Belichtungsmessteil (111, T111, 131) versehene Schaltung zur sensorgesteuerten Entfernungsmessung, bei der zwei lineare, mit Sensorelementen (11 ... 1n, 21 ... 2n) bestückte, jeweils auf einem dotierten Halbleiterkörper (58) integrierte Bildsensoren (1, 2) vorgesehen sind, auf die Ausschnitte einander entsprechender Zeilen zweier von einem Gegenstand getrennt erhaltener Abbildungen projiziert werden, bei der ein Auswerteteil vorhanden ist, der die Sensorsignale in Abhängigkeit von unterschiedlichen relativen Positionsverschiebungen bezüglich einer maximalen Korrelation auswertet, bei der der Belichtungsmessteil zur Bestimmung der Integrationszeit der Sensorelemente (11 ... 1n, 21 ... 2n) dient und bei der dem Auswerteteil eine die Entfernung des Gegenstandes anzeigende Vorrichtung (34) oder eine Vorrichtung zur Scharfeinstellung der Abbildung des Gegenstandes auf eine Bildebene nachgeschaltet ist, dadurch gekennzeichnet, dass den Sensorelementen (11 ... 1n, 21 ... 2n) zur Digitalisierung der Sensorsignale dienende Bewerter (31 ... 3n, 41 ... 4n) nachgeschaltet sind, die in Abhängigkeit vom Überschreiten einer Bezugsladung in den Sensorelementen zwischen zwei unterschiedlichen Schaltzuständen umschaltbar sind, dass der Belichtungsmessteil (111, T111, 131) einen über ein streifenförmig ausgebildetes Vergleichs-Sensorelement (111) angesteuerten Bewerter (131) enthält, dass das Vergleichs-Sensorelement (111) so langgestreckt ausgebildet ist, dass es mit einer optisch erzeugten Ladungsmenge beaufschlagt wird, die einer Vielzahl von Sensorelementen (11 ... 1n) entspricht, dass es weiterhin als Fotodiode (162) ausgebildet und neben wenigstens einem der Bildsensoren (1) angeordnet ist, und dass oberhalb des zwischen den Sensorelementen (11 ... 1n) dieses Bildsensors (1) und dem Vergleichs-Sensorelement (111) liegenden Bereiches des Halbleiterkörpers (58) ein durch eine dünne Isolierschicht (59) von diesem getrenntes, mit einer konstanten Spannung ($U_G$) beaufschlagtes Gate (G; 160, 165) angeordnet ist.

2. Mit einem Belichtungsmessteil versehene Schaltung zur sensorgesteuerten Entfernungsmessung, bestehend aus zwei Schaltungen nach Anspruch 1 mit einem gemeinsamen Auswerteteil und einem gemeinsamen Belichtungsmessteil, dadurch gekennzeichnet, dass einander entsprechende Bildsensoren jeweils zu einer Sensorkombination zusammengefasst sind, dass die Sensorelemente jedes Bildsensors in Längsrichtung desselben so bemessen sind, dass sie etwa der halben Bewerterabmessung (31, 31') in dieser Richtung entsprechen, dass die Sensorelemente eines Bildsensors jeweils in den Lücken zwischen den Sensorelementen des mit diesem zusammengefassten angeordnet sind und dass die Sensorelemente durch das streifenförmige, in Längsrichtung der Sensorkombination verlaufende Vergleichs-Sensorelement (111) und zwei auf einer den Halbleiterkörper abdeckenden Isolierschicht angeordnete, den neben dem Vergleichs-Sensorelement (111) liegenden Halbleiterbereich überdeckende Gateelektroden (G, G'), die mit einer konstanten Spannung ($U_G$) beaufschlagt sind, jeweils in zwei Teile unterteilt sind, die durch eine leitende Überbrückung (LB) miteinander verbunden sind.

3. Schaltung nach Anspruch 1, dadurch gekennzeichnet, dass die beiden Bildsensoren (1, 2) parallel nebeneinander angeordnet sind und die Bewerter (31 ..., 41 ...) und Schieberegister (5, 6) jeweils auf der Seite des ihnen zugeordneten Bildsensors (1, 2) liegen.

4. Schaltung nach einem der Ansprüche 1 bis 3, dadurch gekennzeichnet, dass die den Sensorelementen (11 ...) und dem Vergleichs-Sensorelement (111) nachgeschalteten Bewerter (31 ..., 131) jeweils einen Eingang aufweisen, der über einen Schalttransistor (T11 ..., T111) mit einer Konstantspannungsquelle ($U_{DD}$) verbunden ist.

5. Schaltung nach Anspruch 4, dadurch gekennzeichnet, dass die den Sensorelementen (11 ...) und dem Vergleichs-Sensorelement (111) nachgeschalteten Bewerter (31 ..., 131) jeweils einen weiteren Eingang aufweisen, der über einen weiteren Schalttransistor (T51, T151) mit einer Referenzspannungsquelle $U_{Ref}$ verbunden ist.

6. Schaltung nach einem der vorhergehenden Ansprüche, dadurch gekennzeichnet, dass die Sensorelemente (11 ..., 21 ...) der linearen Bildsensoren (1, 2) als MIS-Kondensatoren (165, 166) ausgebildet sind.

7. Schaltung nach einem der Ansprüche 1 bis 5, dadurch gekennzeichnet, dass die Sensorelemente (11 ..., 21 ...) der linearen Bildsensoren (1, 2) als Fotodioden (60) ausgebildet sind.

8. Schaltung nach einem der Ansprüche 1 bis 5, dadurch gekennzeichnet, dass die Sensorelemente (11 ..., 21 ...) der linearen Bildsensoren (1, 2) als MIS-Kondensatoren (165, 166) ausgebildet sind, zu denen Fotodioden (601) benachbart angeordnet sind.

9. Schaltung nach einem der Ansprüche 1 bis 8, dadurch gekennzeichnet, dass sie wenigstens teilweise auf einem dotierten Halbleiterkörper monolithisch integriert ist.

10. Schaltung nach einem der Ansprüche 1 bis 9, gekennzeichnet durch die Verwendung in einer fotografischen oder elektronischen Kamera.

**Claims**

1. A circuit for sensor-controlled distance measurement with a light measuring means (111, T111, 131), wherein are arranged two linear image sensors (1, 2) equipped with sensor elements (11 ... 1n, 21 ... 2n) and respectively integrated on a doped semiconductor body (58), and onto which sections of mutually corresponding lines of two representations, separately obtained from an object, are projected, wherein is provided an analysing component which analyses the sensor signals in dependence upon different relative position displacements with respect to a maximal correlation, wherein the light measuring means serves to determine the integration time of the sensor elements (11 ... 1n, 21 ... 2n), and wherein the analysing component is followed by a device (34) which displays the distance of the object, or a device for the sharp focussing of the representation of the object onto an image plane, characterised in that the sensor elements (11 ... 1n, 21 ... 2n) are followed by analysers (31 ... 3n, 41 ... 4n) which serve to digitalize the sensor signals and are switchable between two different switching positions in dependence upon a reference charge being exceeded in the sensor elements, that the light measuring means (111, T111, 131) comprises an analyser (131) controlled by a strip-shaped comparison sensor element (111), that the comparison sensor element (111) is elongate in such a manner that it is supplied with an optically produced charge quantity which corresponds to a plurality of sensor elements (11 ... 1n), that it is furthermore designed as a photo-diode (162) and arranged beside at least one of the image sensors (1), and that above the region of the semiconductor body (58) which lies between the sensor elements (11 ... 1n) of this image sensor (1) and the comparison sensor element (111), there is arranged a gate, (G; 160, 165) supplied with a constant voltage ($U_G$) and separated from said region by means of a thin insulating layer (59).

2. A circuit for sensor-controlled distance measurement, with a light measuring means, which consists of two circuits as claimed in Claim 1 with a common analysing component and a common light measuring component, characterised in that mutually corresponding image sensors are respectively combined to form a sensor combination, that the sensor elements of each image sensor are dimensioned in the longitudinal direction thereof in such a manner that they approximately correspond to half of the size of the analyser (31, 31') in this direction, that the sensor elements of an image sensor are respectively arranged in the interspaces between the combined sensor elements, and that the sensor elements are respectively divided into two parts connected to one another by conductive bridging (LB) over the intervening strip-shaped comparison sensor element (111) which extends in the longitudinal direction of the sensor combination, and two gate electrodes (G, G') arranged on an insulating layer covering the semiconductor body, cover the semiconductor region beside the comparison sensor element (111) and are supplied with a constant voltage (U$_G$).

3. A circuit as claimed in Claim 1, characterised in that the two image sensors (1, 2) are arranged parallel to one another and the analysers (31 ..., 41 ...) and shift registers (5, 6) are respectively arranged on the side of the image sensor (1, 2) assigned thereto.

4. A circuit as claimed in one of Claims 1 to 3, characterised in that the analysers (31 ..., 131) connected following the sensor elements (11 ...) and the comparison sensor element (111), respectively have an input connected to a constant voltage source (U$_{DD}$) by means of a switching transistor (T11 .., T111).

5. A circuit as claimed in Claim 4, characterised in that the analysers (31 ..., 131) connected following the sensor elements (11 ...) and the comparison sensor element (111), respectively have a further input connected to a reference voltage source (U$_{Ref}$) by a further switching transistor (T51, T151).

6. A circuit as claimed in one of the preceding Claims, characterised in that the sensor elements (11 ..., 21 ...) of the linear image sensors (1, 2) are designed as MIS-capacitors (165, 166).

7. A circuit as claimed in one of Claims 1 to 5, characterised in that the sensor elements (11 ..., 21 ...) of the linear image sensors (1, 2) are designed as photo-diodes (60).

8. A circuit as claimed in one of Claims 1 to 5, characterised in that the sensor elements (11 ..., 21 ...) of the linear image sensors (1, 2) are designed as MIS-capacitors (165, 166), to which photo-diodes (601) are adjacent.

9. A circuit as claimed in one of Claims 1 to 8, characterised in that it is at least partially monolithically integrated on a doped semiconductor body.

10. A circuit as claimed in one of Claims 1 to 9, characterised by use in a photographic or electronic camera.

## Revendications

1. Circuit pourvu d'un dispositif de mesure de l'exposition (111, T111, 131) en vue de la mesure de la distance commandée par des détecteurs, dans lequel sont prévus des détecteurs d'images (1, 2) linéaires pourvus d'éléments-détecteurs (11 ... 1n, 21 ... 2n), intégrés chacun sur un corps semiconducteur dopé (58) et sur lesquels on projette des sections de lignes, qui se correspondent, de deux images obtenues séparément d'un même objet, dans lequel il est prévu un dispositif d'évaluation qui évalue, du point de vue d'une corrélation maximale, les signaux des détecteurs en fonction de décalages différents et relatifs des positions, dans lequel le dispositif de mesure de l'exposition sert à déterminer le temps d'intégration des éléments-détecteurs (11 ... 1n, 21 ... 2n), et dans lequel on monte en aval du dispositif d'évaluation un dispositif (34) indiquant la distance de l'objet, ou un dispositif de mise au point de l'image de l'objet dans un plan d'image, caractérisé par le fait qu'en aval des éléments détecteurs (11 ... 1n ... 21 ... 2n) on monte des dispositifs de pondération (31 ... 3n, 41 ... 4n) servant à la numérisation des signaux des détecteurs et susceptibles d'être commutés entre deux positions différentes de commutation en fonction du dépassement d'une charge de référence dans les éléments-détecteurs, que le dispositif de mesure de l'exposition (111, T111, 131) comporte un dispositif de pondération (131) commandé par l'intermédiaire d'un élément-détecteur de comparaison (111) réalisé sous la forme d'une bande, que l'élément-détecteur de comparaison (111) est réalisé pour avoir une extension longitudinale qui est telle qu'il est chargé avec une quantité de charges produites par voie optique et qui correspond à plusieurs éléments-détecteurs (11 ... 1n), qu'il est, en outre, réalisé en tant que photodiode (162) et est disposé près d'au moins l'un des détecteurs d'images (1), et qu'au-dessus de la zone du corps semiconducteur (58) qui est située entre les éléments-détecteurs (11 ... 1n) de ce détecteur d'images (1) et l'élément-détecteur de comparaison (111), est disposée une grille (G, 160, 165) chargée par une tension constante (U$_G$) et séparée dudit corps par une couche isolante mince (59).

2. Circuit pourvu d'un dispositif de mesure de l'exposition en vue de la mesure de la distance commandée par des détecteurs, constitué par deux circuits selon la revendication 1 avec un dispositif d'évaluation commun et un dispositif commun de mesure de l'exposition, caractérisé par le fait que des détecteurs d'images qui se correspondent sont assemblés pour former une combinaison de détecteurs, que les éléments-détecteurs de chaque détecteur d'images sont dimensionnés dans le sens longitudinal de ce dernier de façon à correspondre à peu près, dans cette direction, à la moitié de la dimension des dispositifs de pondération (31, 31'), que les éléments-détecteurs d'un détecteur d'images sont chacun disposés dans les intervalles situés entre les éléments-détecteurs qui sont rassemblés avec ce dernier, que les éléments-détecteurs sont divisés, par l'intermédiaire de l'élément-détecteur de comparaison (111) en forme de bande et s'étendant dans la direction longitudinale de la combinaison de détecteurs, ainsi que par deux électrodes de grille (G, G') chargées par une tension constante (U$_G$), disposées sur une couche isolante recouvrant le corps semiconducteur et recouvrant la zone du semiconducteur située près de l'élément-détecteur de comparaison (111), en deux parties qui sont reliées entre elles par un pont conducteur (LB).

3. Circuit selon la revendication 1, caractérisé par le fait que les deux détecteurs d'images (1, 2) sont disposés parallèlement l'un à côté de l'autre, et les dispositifs de pondération (31 ..., 41 ...) et des registres à décalage (5, 6) se situent respectivement sur le côté du détecteur d'images (1, 2) qui leur est associé.

4. Circuit selon l'une des revendications 1 à 3, caractérisé par le fait que les dispositifs de pondération (31 ..., 131) qui sont montés en aval des éléments-détecteurs (11 ...) et de l'élément-détecteur de comparaison (111), comportent, chacun, une entrée qui est reliée, par l'intermédiaire d'un transistor de commutation (T1 ... T111). à une source de tension constante ($U_{DD}$).

5. Circuit selon la revendication 4, caractérisé par le fait que les dispositifs de pondération (31 ..., 131) qui sont montés en aval des éléments-détecteurs (11 ...) et de l'élément-détecteur de comparaison (111), comportent, chacun, une seconde entrée qui est reliée, par l'intermédiaire d'un second transistor de commutation (T51, T151), à une source de tension de référence ($U_{Ref}$).

6. Circuit selon l'une des revendications précédentes, caractérisé par le fait que les éléments-détecteurs (11 ..., 21 ...) des détecteurs d'images (1, 2) sont réalisés sous la forme de condensateurs MIS (165, 166).

7. Circuit selon l'une des revendications 1 à 5, caractérisé par le fait que les éléments-détecteurs (11 ..., 21 ...) des détecteurs d'images linéaires (1, 2) sont réalisés sous la forme de photodiodes (60).

8. Circuit selon l'une des revendications 1 à 5, caractérisé par le fait que les éléments-détecteurs (11 ..., 21 ...) des détecteurs d'images linéaires (1, 2) sont réalisés sous la forme de condensateurs MIS (165, 166) auxquels sont associées, en positions voisines, des photodiodes (601).

9. Circuit selon l'une des revendications 1 à 8, caractérisé par le fait qu'il est au moins partiellement intégré monolithiquement sur un corps semiconducteur dopé.

10. Circuit selon l'une des revendications 1 à 9, caractérisé par sa mise en œuvre d'une camera photographique ou électronique.

FIG 1

# FIG 2

# FIG 3

FIG 4

FIG 5

FIG 6

# FIG 7

# FIG 8